# EUROPÄISCHE PATENTANMELDUNG

(11) **EP 3 182 145 A1**
(43) Veröffentlichungstag der Anmeldung: **21.06.2017**
(21) Anmeldenummer: 16203584.4
(22) Anmeldetag: 13.12.2016
(51) Int. Cl.: G01R 31/11, G01R 31/02

(54) **VERFAHREN UND VORRICHTUNG ZUR ERWEITERTEN ISOLATIONSFEHLERSUCHE IN EINEM UNGEERDETEN STROMVERSORGUNGSSYSTEM UND VERFAHREN ZUR ZUSTANDSÜBERWACHUNG DES STROMVERSORGUNGSSYSTEMS**

(30) Priorität: 17.12.2015 DE 102015122128
(71) Anmelder: Bender GmbH & Co. KG, 35305 Grünberg (DE)
(72) Erfinder: MÖLL, Dipl.-Ing. Winfried, 35321 Laubach (DE); BRÖCKMANN, Dr. Eckhard, 35396 Gießen (DE); SCHÄFER, Dipl.-Ing. Oliver, 35305 Grünberg (DE); MAGER, Dipl.-Ing. Torsten, 36318 Schwalmtal (DE)
(74) Vertreter: advotec.

(57) **Zusammenfassung**

Die Erfindung betrifft ein Verfahren zur Isolationsfehlersuche in einem verzweigten, ungeerdeten Stromversorgungssystem (4, 6), wobei in Kombination mit der Auswertung einer Information zur Erkennung eines fehlerhaften Leitungsabgangs (14) eine Bestimmung eines Isolationsfehlerortes nach einem Verfahren der Zeitbereichsreflektometrie erfolgt.

Weiterhin betrifft die Erfindung ein Verfahren zur Isolationsfehlererkennung in einem verzweigten Stromversorgungssystem und zur Zustands-überwachung des verzweigten Stromversorgungssystems, wobei auf Basis eines Verfahrens der Zeitbereichsreflektometrie eine Abbildung aller Reflexionsorte auf dem Stromversorgungssystem erfolgt.

Darüber hinaus betrifft die Erfindung eine Vorrichtung (2) zur Isolationsfehlersuche in einem verzweigten, ungeerdeten Stromversorgungssystem (4, 6), mit den Funktionseinheiten Isolationsfehlerprüfeinrichtung (12) und Isolationsfehler-Auswerteeinrichtung (16) mit Messstromwandler (18, 20), wobei die Vorrichtung in Umsetzung des erfindungsgemäßen Verfahrens eine Zeitbereichsreflektometrie-Messeinrichtung (30) mit einer Steuer- und Auswerteeinrichtung (32) aufweist.

## Beschreibung

Die Erfindung betrifft ein Verfahren zur Isolationsfehlersuche in einem verzweigten, ungeerdeten Stromversorgungssystem, wobei das Verfahren die Verfahrensschritte Einspeisen eines Prüfstroms in mindestens einen aktiven Leiter des ungeerdeten Stromversorgungssystems, Erfassen eines Prüfstromanteils in einem Leitungsabgang des ungeerdeten Stromversorgungssystems und Auswerten des erfassten Prüfstromanteils zur Erkennung eines fehlerhaften Leitungsabgangs umfasst.

Weiterhin betrifft die Erfindung ein Verfahren zur Isolationsfehlererkennung in einem verzweigten Stromversorgungssystem und zur Zustandsüberwachung des verzweigten Stromversorgungssystems.

Darüber hinaus betrifft die Erfindung eine Vorrichtung zur Isolationsfehlersuche in einem verzweigten, ungeerdeten Stromversorgungssystem, mit den Funktionseinheiten Isolationsfehlerprüfeinrichtung und Isolationsfehler-Auswerteeinrichtung mit Messstromwandler.

Verfahren zur Isolationsfehlersuche und die diese Verfahren umsetzenden Vorrichtungen (Isolationsfehlersucheinrichtungen) sind aus dem Stand der Technik bekannt und werden zur Lokalisierung von Isolations-fehlern in Stromversorgungsystemen, vornehmlich zur Bestimmung des fehlerhaften Leitungsabgangs bei Auftreten eines in ungeerdeten Netzen aufgetretenen ersten (Isolations-)Fehlers, eingesetzt.

Tritt in dem ungeerdeten Stromversorgungssystem ein Isolationsfehler auf, wird dieser zunächst von einem Isolationsüberwachungsgerät erkannt und gemeldet. Mit dieser Meldung startet die Isolationsfehlersuche indem das Isolationsüberwachungsgerät oder eine IsolationsfehlerPrüfeinrichtung, die auch als Bestandteil einer Isolationsfehlersucheinrichtung als Isolationsfehler-Prüfgerät ausgeführt sein kann, einen Prüfstrom erzeugt und in das Stromversorgungssystem einspeist. Dieses Prüfstromsignal wird von allen Messstromwandlern, die in dem Fehlerstromkreis mit dem fehlerbehafteten Leitungsabgang liegen, erfasst und durch eine Isolationsfehler-Auswerteeinrichtung ausgewertet und angezeigt. Durch die Zuordnung Messstromwandler zu Stromkreis bzw. Leitungsabgang kann der fehlerhafte Leitungsabgang bestimmt werden.

Dabei wird zwar der mit dem Isolationsfehler behaftete Leitungsabgang in dem verzweigten Stromversorgungssystem erkannt, nicht aber der genaue Ort des Isolationsfehlers auf diesem fehlerhaften Leitungsabgang.

Zur schnellen Behebung des Isolationsfehlers aber ist eine Kenntnis des genauen Fehlerortes auf dem fehlerbehafteten Leitungsabgang hilfreich.

Der vorliegenden Erfindung liegt somit die Aufgabe zu Grunde, ein Verfahren und eine Vorrichtung zu entwickeln, mit denen der genaue Fehlerort eines Isolationsfehlers auf einem fehlerhaften Leitungsabgang eines ungeerdeten Stromversorgungssystems bestimmt werden kann.

Diese Aufgabe wird bezogen auf ein Verfahren in Verbindung mit dem Oberbegriff des Anspruchs 1 dadurch gelöst, dass in Kombination mit der Auswertung einer Information zur Erkennung des fehlerhaften Leitungsabgangs eine Bestimmung eines Isolationsfehlerortes nach einem Verfahren der Zeitbereichsreflektometrie erfolgt.

Der Grundgedanke der vorliegenden Erfindung beruht in vorteilhafter Weise darauf, das mittels einer nach dem Stand der Technik durchgeführten Isolationsfehlersuche gewonnene Wissen über die Lage eines fehlerhaften Leitungsabgangs mit dem Ergebnis einer Fehlerortlokalisierung nach einem Verfahren der Zeitbereichsreflektometrie zu kombinieren. Mittels einer weitgehend auf bekannten Mechanismen der Prüfstrom-Einspeisung und Prüfstrom-Auswertung beruhenden IsolationsFehlersuche wird der mit einem Isolationsfehler behaftete Leitungsabgang in dem verzweigten Stromversorgungssystem identifiziert. Auf Basis dieser Information wird auf dem als fehlerhaft erkannten Leitungsabgang der genaue Fehlerort mittels eines nach einem Verfahren der Zeitbereichsreflektometrie erzeugten Messimpulses bestimmt. Auch können die durch das Verfahren der Zeitbereichsreflektometrie im Rahmen einer permanenten Zustandsüberwachung des Stromversorgungssystems gewonnenen Informationen parallel für die Bestimmung des Fehlerortes herangezogen werden.

Durch die Verknüpfung der Erkenntnisse aus den beiden Maßnahmen - "klassisches" Isolationsfehlersuch-Verfahren einerseits und Störquellenortung mittels Zeitbereichsreflektometrie andererseits - kann der Isolationsfehler zuverlässig erkannt, dessen genaue Position bestimmt, und damit im Interesse der elektrischen Sicherheit schnell behoben werden.

In weiterer vorteilhafter Ausgestaltung umfasst die Bestimmung des Isolationsfehlerortes auf dem als fehlerhaft erkannten Leitungsabgang die folgenden Verfahrensschritte: (a) Erzeugen des Zeitbereichsreflektometrie-Messimpulses und Einspeisen des Messimpulses in den/die aktiven Leiter des Stromversorgungssystems, (b) im Isolationsfehler-freien Fall Empfangen und Aufzeichnen eines ersten reflektierten Messsignals bestehend aus einer ersten Folge von reflektierten Messimpulsen als zeitliche Abbildung aller Reflexionsorte in dem Stromversorgungssystem, (c) bei Auftreten eines Isolationsfehlers Empfangen eines zweiten reflektierten Messsignals bestehend aus einer zweiten Folge von reflektierten Messimpulsen, (d) aus dem ersten reflektierten Messsignal und dem zweiten reflektierten Messsignal Ableiten eines Differenzsignals, das den Isolationsfehler repräsentiert und (e) Bestimmen des Isolationsfehlerortes auf dem erkannten fehlerhaften Leitungsabgang durch Auswerten einer Laufzeit des den Isolationsfehler repräsentierenden Differenzsignals unter Hinzuziehen der Information, welcher Leitungsabgang als fehlerhaft erkannt worden ist.

Nach der Generierung und Einspeisung des Messimpulses wird zunächst im fehlerfreien Fall des Stromversorgungssystems - ein fehlerfreier Fall liegt vor, falls ein in dem Stromversorgungssystem installiertes Isolationsüberwachungsgerät keinen Isolationsfehler meldet - ein reflektiertes Messsignal empfangen und aufgezeichnet. Das reflektierte Messsignal besteht aus einer ersten Folge von reflektierten Messimpulsen, die eine zeitliche Abbildung aller Reflexionsorte in dem Stromversorgungssystem darstellen. Dieses in einer "Lernphase" hinterlegte Reflexionsprofil des fehlerfreien Stromversorgungssystems dient als Referenzmuster für den Vergleich mit einem nach dem Auftreten eines zweiten Fehlers empfangenen zweiten reflektierten Messsignal - das Auftreten des Isolationsfehlers wird durch das Isolationsüberwachungsgerät signalisiert. Dieses zweite Messsignal besteht aus einer zweiten Folge von reflektierten Messimpulsen, die nun gegenüber der als Referenzmuster abgespeicherten ersten Folge einen zusätzlichen reflektierten "Isolationsfehler"-Messimpuls aufweist. Durch einen direkten Vergleich des ersten reflektierten Messsignals mit dem zweiten reflektierten Messsignal oder einen mittelbaren Vergleich, der zunächst die empfangenen Messimpulse über Korrelationsberechnungen in Korrelationsfunktionen überführt, wird ein Differenzsignal abgeleitet, das den Isolationsfehler repräsentiert. Durch Auswerten einer Laufzeit - die Ausbreitungsgeschwindigkeit des Messsignals auf der Leitung sei bekannt - des den Isolationsfehler repräsentierenden Differenzsignals, kann in Kenntnis des fehlerhaften Leitungsabgangs der genaue Fehlerort bestimmt werden.

Während der Lernphase kann eine Zuordnung der empfangenen Messimpulse zu Leitungsabgängen über bekannte systembedingte Reflexionen (beispielsweise bekannte Leitungsabschlüsse) oder über Test-Reflexionen erfolgen. Grundsätzlich kann aber auch die alleinige Kenntnis, dass ein Isolationsfehler auf einem bekannten Leitungsabgang aufgetreten ist, ausreichen, um einen neu hinzugekommenen Messimpuls als Isolationsfehler-Messimpuls zu identifizieren.

Weiteren Ausgestaltungen gemäß kann die Erzeugung und Einspeisung des Messsignals sowie die Verarbeitung des reflektierten Messsignals nach verschiedenen Verfahren erfolgen, die alle auf dem Prinzip der Zeitbereichsreflektometrie beruhen.

Dabei ist es nicht die Aufgabe der vorliegenden Erfindung, einen sporadisch auftretenden Isolationsfehler während seines Auftretens zu lokalisieren - wie in einer typischen Anwendung des SSTDR-Verfahrens, siehe unten -, sondern in Kombination mit einer konventionellen Isolationsfehlersucheinrichtung den Fehlerort eines bestehenden Isolationsfehlers zu lokalisieren.

Im einfachsten Fall kann ein Einzelimpuls als Messimpuls erzeugt und eingespeist werden. Der Einzelimpuls ist dabei vorzugsweise ein steilflankiger Impuls in Form eines Rechteckimpulses, wobei der reflektierte Messimpuls unmittelbar oder mittels Korrelationsberechnung zur weiteren Verarbeitung herangezogen werden kann. Zur Störquellenortung mittels Laufzeitmessung ist diese Variante der Zeitbereichsreflektometrie als TDR-Verfahren (Time Domain Reflectometry) bekannt.

Als weniger störanfällig erweist es sich, wenn bevorzugt ein Spreizcode als Messimpuls mit spektraler Spreizung verwendet wird und die Verarbeitung des reflektierten Messsignals in einer Korrelationsberechnung des bekannten Spreizcodes mit dem empfangenen reflektierten Messsignal erfolgt (STDR - Sequence Time Domain Reflectometry) oder wenn ein Spreizcode als Messimpuls mit spektraler Spreizung verwendet wird, wobei der Spreizcode ein sinusförmiges Trägersignal moduliert und die Verarbeitung des reflektierten Messsignals in einer Korrelationsberechnung des bekannten Spreizcodes mit dem empfangenen reflektierten Messsignal erfolgt (SSTDR - Spread Spectrum Time Domain Reflectometry).

Beide letztgenannten Verfahren verwenden als Messimpuls ein als Spreizcode bezeichnetes Signal mit Frequenzspreizung, um in Verbindung mit einer Korrelationsberechnung Störeinflüssen auf der Erdverbindung besser begegnen zu können. Zudem kommen diese Verfahren im Vergleich zu dem TDR-Verfahren mit einer geringeren Leistung aus.

In dem SSTDR-Verfahren findet durch die Multiplikation des Spreizcodes mit einem sinusförmigen Trägersignal (Modulation des Trägersignals) zusätzlich eine Frequenzverschiebung des gespreizten Spektrums in einen für die Übertragung des Messsignals geeigneten Frequenzbereich statt.

Als Spreizcode werden vorzugsweise eine Pseudo-Zufallssequenz oder zwei zeitlich abwechselnd gesendete Sequenzen eines komplementären Codes (Complementary Code) verwendet.

Diese Sequenzen zeichnen sich durch ihre guten Korrelationseigenschaften aus, wobei insbesondere die Sequenzen eines Komplementärcodes eine Autokorrelationsfunktion aufweisen, deren Werte außerhalb des zentralen Wertes (Nullverschiebung) exakt Null sind.

Das weiter beanspruchte Verfahren zur Isolationsfehlererkennung in einem verzweigten Stromversorgungssystem und zur Zustandsüberwachung des verzweigten Stromversorgungssystems zeichnet sich dadurch aus, dass auf Basis eines Verfahrens der Zeitbereichsreflektometrie eine Abbildung aller Reflexionsorte auf dem Stromversorgungssystem als Reflexionsprofil des Stromversorgungssystem zu einem bestimmten Zeitpunkt ermittelt und ein Vergleich zeitlich nacheinander ermittelter Reflexionsprofile durchgeführt wird. Ein Unterschied zwischen den verglichenen Reflexionsprofilen liefert einen Hinweis auf eine Änderung eines elektrischen Zustands des Stromversorgungssystems.

Indem in regelmäßigen zeitlichen Abständen ein reflektiertes Messsignal als Reflexionsprofil des Stromversorgungssystems aufgezeichnet und jeweils mit dem vorhergehend aufgezeichneten Reflexionsprofil verglichen wird, können Änderungen des elektrischen Zustands des Stromversorgungssystems erkannt werden. Diese permanente Zustandsüberwachung erlaubt beispielsweise Rückschlüsse auf geänderte Netzkonstellationen oder Betriebszustände (z. B. Lastwechsel).

Bezogen auf eine Vorrichtung wird die Aufgabe gelöst durch eine Vorrichtung zur Isolationsfehlersuche in einem verzweigten, ungeerdeten Stromversorgungssystem, umfassend die Funktionseinheiten Isolationsfehlerprüfeinrichtung und Isolationsfehler-Auswerteeinrichtung mit Messstromwandler, die erfindungsgemäß eine Zeitbereichsreflektometrie-Messeinrichtung mit einer Steuer- und Auswerteeinrichtung zur Steuerung von Funktionsabläufen der Zeitbereichsreflektometrie-Messung unter Einbeziehung der von der Isolationsfehler-Auswerteeinrichtung bereitgestellten Information zur Erkennung des fehlerhaften Leitungsabgangs aufweist.

In Umsetzung des erfindungsgemäßen Verfahrens weist die korrespondierende Vorrichtung eine Zeitbereichsreflektometrie-Messeinrichtung mit einer Steuer- und Auswerteeinrichtung auf. In diesen Einrichtungen sind die dem Verfahren zugrundeliegenden Verfahrensschritte implementiert.

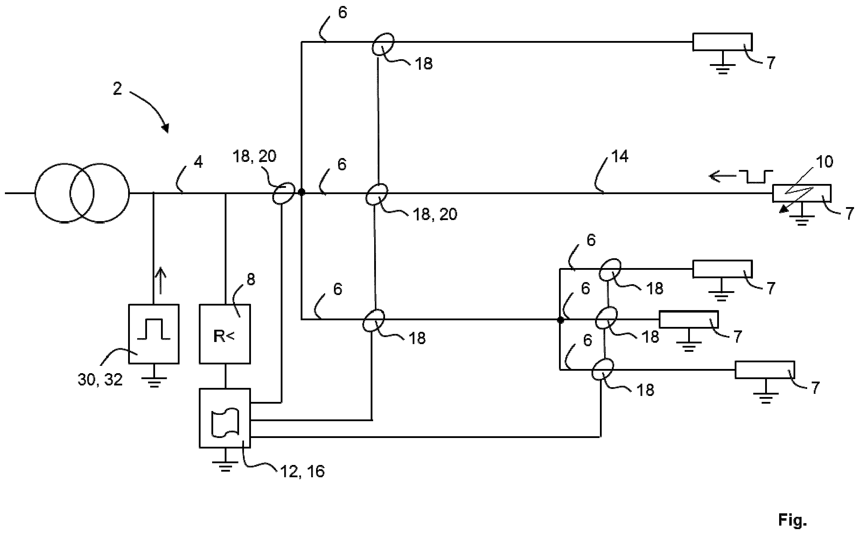

Weitere vorteilhafte Ausgestaltungsmerkmale ergeben sich aus der nachfolgenden Beschreibung und der Zeichnung, die eine bevorzugte Ausführungsform der Erfindung an Hand eines Beispiels erläutert.

Die **Fig.** zeigt in schematischer Darstellung einen beispielhaften Anwendungsfall des erfindungsgemäßen Verfahrens und der das Verfahren umsetzenden Funktionseinheiten 12, 16, 30, 32 einer Vorrichtung zur Isolationsfehlersuche in einem verzweigten, ungeerdeten Stromversorgungssystems 2, das aus einem Hauptsystem 4 mit mehreren Leitungsabgängen 6 besteht, die wiederum weitere Leitungsabgänge 6 umfassen, an die jeweils eine Last 7 angeschlossen ist. Die Leitungsabgänge 6 weisen in der Regel unterschiedliche Leitungslängen auf.

Das Stromversorgungssystem 2 wird von einem Isolationsüberwachungsgerät 8 ständig auf das Auftreten eines Isolationsfehlers 10 überwacht. Ist ein derartiger Isolationsfehler 10 aufgetreten, so startet eine Isolationsfehlerprüfeinrichtung 12 die Isolationsfehlersuche zur Bestimmung des fehlerhaften Leitungsabgangs 14 durch Einspeisen eines Prüfstroms in das Stromversorgungsystem 2. In einer Isolationsfehler-Auswerteeinrichtung 16 werden die von Messstromwandlern 18 erfassten Signale ausgewertet, sodass anhand derjenigen Messstromwandler 20, die infolge des Isolationsfehlers 10 von dem Prüfstrom durchflossenen werden, der fehlerhafte Leitungsabgang 14 identifiziert werden kann.

Zusätzlich speist bei einem aufgetretenen Isolationsfehler 10 die Zeitbereichsreflektometrie-Messeinrichtung 30 einen Zeitbereichsreflektometrie-Messimpuls in das Stromversorgungssystem 2 ein. Dieser Messimpuls wird an allen Diskontinuitäten des Leitungswellenwiderstands (Impedanz-Fehlanpassung) der Leitungen des Stromversorgungssystems 2 reflektiert, so dass als empfangenes reflektiertes Messsignal eine Folge von reflektierten Messimpulsen als zeitliche Abbildung aller Reflexionsorte in dem Stromversorgungssystem 2 entsteht. Im Vergleich zu einem fehlerfreien Fall weist das reflektierte Messsignal bei Auftreten eines Fehlers 10 - der eine Impedanz-Fehlanpassung darstellt - einen zusätzlichen, durch den Isolationsfehler 10 bedingten, reflektierten "Isolationsfehler"-Messimpuls auf, wobei die Entfernung seines Entstehungsortes (die Strecke zwischen "Isolationsfehler"-Reflexionsort und Zeitbereichsreflektometrie-Messeinrichtung 30) aus der Laufzeit bestimmbar ist. In Zusammenführung mit der Information aus der Isolationsfehler-Auswerteeinrichtung 16 darüber, welcher Leitungsabgang 20 als fehlerhaft erkannt worden ist, kann somit der Ort des Isolationsfehlers 10 genau bestimmt werden.

Insoweit können die beiden Mechanismen konventionelle Isolationsfehlersuche und Zeitbereichsreflektometrie-Messung insbesondere in weitverzweigten Stromversorgungssystemen mit schwachen reflektierten Messimpulsen einander unterstützend wirken.

Eine Steuer- und Auswerteeinrichtung 32 steuert die Funktionsabläufe der Zeitbereichsreflektometrie-Messung in Abhängigkeit der von der Isolationsfehler-Auswerteeinrichtung bereitgestellten Information zur Erkennung des fehlerhaften Leitungsabgangs 14.

Die Funktionseinheiten Isolationsfehlerprüfeinrichtung 12, Isolationsfehler-Auswerteeinrichtung 16 und Zeitbereichsreflektometrie-Messeinrichtung 30 mit Steuer- und Auswerteeinrichtung 32 können dabei vorteilhaft in einer baulichen Einheit als erweiterte Isolationsfehler-Sucheinrichtung zusammengefasst sein. Diese erweiterte Isolationsfehler-Sucheinrichtung kann darüber hinaus mit einem Isolationsüberwachungsgerät 8 baulich integriert werden.

## Patentansprüche

1. Verfahren zur Isolationsfehlersuche in einem verzweigten, ungeerdeten Stromversorgungssystem, umfassend die Verfahrensschritte:
- Einspeisen eines Prüfstroms zur Bestimmung eines fehlerhaften Leitungsabgangs in mindestens einen aktiven Leiter des ungeerdeten Stromversorgungssystems,
- Erfassen eines Prüfstromanteils in einem Leitungsabgang des ungeerdeten Stromversorgungssystems,
- Auswerten des erfassten Prüfstromanteils zur Erkennung eines fehlerhaften Leitungsabgangs,
**dadurch gekennzeichnet,**
**dass** in Kombination mit der Auswertung einer Information zur Erkennung des fehlerhaften Leitungsabgangs eine Bestimmung eines Isolationsfehlerortes mittels eines nach einem Verfahren der Zeitbereichsreflektometrie erzeugten Messimpulses erfolgt.

2. Verfahren nach Anspruch 1,
**dadurch gekennzeichnet,**
**dass** die Bestimmung des Isolationsfehlerortes auf dem als fehlerhaft erkannten Leitungsabgang die folgenden Verfahrensschritte umfasst:
- (a) Erzeugen des Zeitbereichsreflektometrie-Messimpulses und Einspeisen des Messimpulses in den/die aktiven Leiter des Stromversorgungssystems,
- (b) im Isolationsfehler-freien Fall Empfangen und Aufzeichnen eines ersten reflektierten Messsignals bestehend aus einer ersten Folge von reflektierten Messimpulsen als zeitliche Abbildung aller Reflexionsorte in dem Stromversorgungssystem,
- (c) bei Auftreten eines Isolationsfehlers Empfangen eines zweiten reflektierten Messsignals bestehend aus einer zweiten Folge von reflektierten Messimpulsen,
- (d) aus dem ersten reflektierten Messsignal und dem zweiten reflektierten Messsignal Ableiten eines Differenzsignals, das den Isolationsfehler repräsentiert,
- (e) Bestimmen des Isolationsfehlerortes auf dem erkannten fehlerhaften Leitungsabgang durch Auswerten einer Laufzeit des den Isolationsfehler repräsentierenden Differenzsignals unter Hinzuziehen der Information, welcher Leitungsabgang als fehlerhaft erkannt worden ist.

3. Verfahren nach Anspruch 2,
**dadurch gekennzeichnet,**
**dass** ein Einzelimpuls als Messimpuls erzeugt und eingespeist wird.

4. Verfahren nach Anspruch 2,
**dadurch gekennzeichnet,**
**dass** ein Spreizcode als Messimpuls mit spektraler Spreizung verwendet wird und eine Verarbeitung des reflektierten Messsignals in einer Korrelationsberechnung des bekannten Spreizcodes mit dem empfangenen reflektierten Messimpuls erfolgt.

5. Verfahren nach Anspruch 2,
**dadurch gekennzeichnet,**
**dass** ein Spreizcode als Messimpuls mit spektraler Spreizung verwendet wird, wobei der Spreizcode ein sinusförmiges Trägersignal moduliert und eine Verarbeitung des reflektierten Messsignals in einer Korrelationsberechnung des bekannten Spreizcodes mit dem empfangenen reflektierten Messimpuls erfolgt.

6. Verfahren nach Anspruch 4 oder 5,
**dadurch gekennzeichnet,**
**dass** eine Pseudo-Zufallssequenz als Spreizcode verwendet wird.

7. Verfahren nach Anspruch 4 oder 5,
**dadurch gekennzeichnet,**
**dass** als Spreizcodes zwei zeitlich abwechselnd gesendete Sequenzen eines komplementären Codes verwendet werden.

8. Verfahren zur Isolationsfehlererkennung in einem verzweigten Stromversorgungssystem und zur Zustandsüberwachung des Stromversorgungssystems,
**dadurch gekennzeichnet,**
**dass** auf Basis eines Verfahrens der Zeitbereichsreflektometrie eine Abbildung aller Reflexionsorte auf dem Stromversorgungssystem als Reflexionsprofil des Stromversorgungssystem zu einem bestimmten Zeitpunkt ermittelt und ein Vergleich zeitlich nacheinander ermittelter Reflexionsprofile durchgeführt wird, wobei ein Unterschied zwischen den verglichenen Reflexionsprofilen einen Hinweis auf eine Änderung eines elektrischen Zustands des Stromversorgungssystems liefert

9. Vorrichtung zur Isolationsfehlersuche in einem verzweigten, ungeerdeten Stromversorgungssystem, umfassend die Funktionseinheiten Isolationsfehlerprüfeinrichtung und Isolationsfehler-Auswerteeinrichtung mit Messstromwandler zur Bestimmung eines fehlerhaften Leitungsabgangs,
**gekennzeichnet durch**
eine Zeitbereichsreflektometrie-Messeinrichtung mit einer Steuer- und Auswerteeinrichtung zur Steuerung von Funktionsabläufen der Zeitbereichsreflektometrie-Messung unter Einbeziehung der von der Isolationsfehler-Auswerteeinrichtung bereitgestellten Information zur Erkennung des fehlerhaften Leitungsabgangs.

10. Vorrichtung nach Anspruch 9,
**dadurch gekennzeichnet,**
**dass** die Steuer- und Auswerteeinrichtung zur Steuerung von Funktionsabläufen der Zeitbereichsreflektometrie-Messung so ausgeführt ist, dass im fehlerfreien Fall des Stromversorgungssystems ein erstes reflektiertes Messsignal oder ein daraus abgeleitetes Signal als Referenzmuster aufgezeichnet wird, das bei Eintritt eines Fehlerfalles mit einem aktuell ermittelten zweiten reflektierten Messsignal oder einem daraus abgeleiteten Signal verglichen wird, um ein den Isolationsfehlerort repräsentierendes Differenzsignal zu erhalten und in Verbindung mit der Information über den erkannten fehlerhaften Leitungsabgang den genauen Fehlerort durch Laufzeitauswertung zu bestimmen.
